# EUROPEAN PATENT APPLICATION

(11) **EP 4 852 703 A1**
(43) Date of publication of application: **09.12.2026**
(21) Application number: 25824543.0
(22) Date of filing: 28.03.2025
(51) Int. Cl.: H10W 74/10

(54) **HEAT DISSIPATION PACKAGE STRUCTURE AND ELECTRONIC DEVICE**

(30) Priority: 24.06.2024 CN 202410822119
(71) Applicant: HUAWEI TECHNOLOGIES CO., LTD., Shenzhen, Guangdong 518129 (CN)
(72) Inventor: ZHAO, Xing, Shenzhen, Guangdong 518129 (CN); MA, Tian, Shenzhen, Guangdong 518129 (CN); WANG, Song, Shenzhen, Guangdong 518129 (CN); JIA, Chenlu, Shenzhen, Guangdong 518129 (CN); HONG, Yaqin, Shenzhen, Guangdong 518129 (CN); JIANG, Feng, Shenzhen, Guangdong 518129 (CN); GUO, Tinghui, Shenzhen, Guangdong 518129 (CN); WANG, Junjun, Shenzhen, Guangdong 518129 (CN); TU, Yiming, Shenzhen, Guangdong 518129 (CN)
(74) Representative: Maiwald GmbH
(86) International application number: PCT/CN2025/085832
(87) International publication number: WO 2026/001150

(57) **Abstract**

This application provides a heat dissipation package structure and an electronic device. The heat dissipation package structure includes a circuit board and a heat sink. A chip is disposed on the circuit board, and a surface of the chip is coated with liquid metal. The heat sink is disposed on a side of the chip that is away from the circuit board. The heat sink is in contact with the chip through the liquid metal, and the liquid metal is configured to transfer heat from the chip to the heat sink. A first sealing frame is disposed on an outer periphery of the chip, and a second sealing frame is disposed on an outer periphery of the first sealing frame. The first sealing frame is configured to seal the chip and the liquid metal, and the second sealing frame is configured to block external air. In this application, the first sealing frame is an inner sealing frame, and the second sealing frame is an outer sealing frame. The first sealing frame prevents the liquid metal from flowing out, and the second sealing frame provides additional protective sealing, blocks moisture from entering, and prevents the liquid metal from coming into contact with air and undergoing oxidation. This enables long-term sealing of the liquid metal, prevents moisture infiltration, corrosion, and liquid leakage, and improves long-term heat dissipation performance of a system.

## Description

This application claims priority to Chinese Patent Application No. 202410822119.0, filed with the China National Intellectual Property Administration on June 24, 2024 and entitled "HEAT DISSIPATION PACKAGE STRUCTURE AND ELECTRONIC DEVICE", which is incorporated herein by reference in its entirety.

### TECHNICAL FIELD

This application relates to the field of heat dissipation of electronic devices, and more specifically, to a heat dissipation package structure and an electronic device.

### BACKGROUND

To improve heat dissipation of a chip in an electronic device, a high-performance thermally conductive material is usually used between the chip and a heat sink, to meet high-density heat dissipation requirements of the electronic device. Therefore, liquid metal, as a thermal interface material with high thermal conductivity and ultra-low thermal resistance during application, has been gradually used in electronic devices. A frequently used liquid metal is usually a gallium-based liquid metal, which readily undergoes oxidation reactions with oxygen/water vapor, and is prone to causing corrosion of metals such as aluminum and copper, ultimately causing degradation of heat-conducting performance. Therefore, during actual application, sealing protection needs to be performed to achieve anti-oxidation and anti-leakage effects.

Currently, sealing solutions for the liquid metal has high requirements for the barrier properties of a sealing material, and requires a large structural space and a high locking force. In addition, the sealing solution is susceptible to moisture infiltration, mechanical vibration, and long-term reduction in sealing pressure, leading to problems of a long-term sealing failure, liquid leakage, and degraded heat dissipation efficiency of a system.

### SUMMARY

This application provides a heat dissipation package structure and an electronic device, to enable long-term sealing of liquid metal, prevent moisture infiltration, corrosion, and liquid leakage, and improve long-term heat dissipation performance of a system.

According to a first aspect, a heat dissipation package structure is provided. The heat dissipation package structure includes a circuit board and a heat sink. A chip is disposed on the circuit board, and a surface of the chip is coated with liquid metal. The heat sink is disposed on a side of the chip that is away from the circuit board. The heat sink is in contact with the chip through the liquid metal, and the liquid metal is configured to transfer heat from the chip to the heat sink. A first sealing frame is disposed on an outer periphery of the chip, and a second sealing frame is disposed on an outer periphery of the first sealing frame. The first sealing frame is configured to seal the chip and the liquid metal, and the second sealing frame is configured to block external air from entering the first sealing frame, thereby preventing external air from entering the first sealing frame and preventing the liquid metal in the first sealing frame from undergoing an oxidation reaction with the external air.

It should be understood that the heat sink is made of a metal material (for example, copper or aluminum), and may mainly have a heat dissipation function. The chip in an embodiment of this application may be replaced with a heat emitting element. In other words, the heat dissipation package structure in this application may be used to dissipate heat from a heat emitting element other than the chip.

In this embodiment of this application, the first sealing frame serves as an inner sealing frame, and the second sealing frame serves as an outer sealing frame. The first sealing frame provides first-layer protective sealing to prevent the liquid metal in the first sealing frame from flowing out. The second sealing frame can provide additional protective sealing to prevent the liquid metal that overflows beyond the first sealing frame from continuing to overflow outward, and therefore damaging a peripheral component. In addition, the second sealing frame may further block moisture, thereby preventing the liquid metal that overflows beyond the first sealing frame from coming into contact with air and undergoing the oxidation reaction. Finally, long-term sealing of the liquid metal can be implemented, which prevents moisture infiltration, corrosion, and leakage of the liquid metal, prolongs a service life of the liquid metal, and improves long-term heat dissipation performance of the chip to meet a high-density heat dissipation requirement of the chip.

With reference to the first aspect, in some implementations of the first aspect, a ratio of sealed space enclosed by the first sealing frame to an amount of the liquid metal is greater than 2.

For example, the ratio of the sealed space enclosed by the first sealing frame to the amount of the liquid metal may range from 2.5 to 3. This ensures heat dissipation performance of a system, and avoids leakage caused by an excessive amount of the liquid metal.

In this embodiment of this application, the amount and costs of the liquid metal are comprehensively considered. The ratio of the sealed space enclosed by the first sealing frame to the amount of the liquid metal may be limited to be greater than 2, and may further range from 2.5 to 3.

With reference to the first aspect, in some implementations of the first aspect, a width of the first sealing frame is greater than 1 mm, and/or a width of the second sealing frame is greater than 1 mm.

For example, the width of the first sealing frame and/or the width of the second sealing frame may be greater than 2 mm.

In this embodiment of this application, the width of the first sealing frame and/or the width of the second sealing frame is limited to be greater than 1 mm, to prevent sealing effect from being affected by an excessively narrow width. An appropriate width can implement sealing against water vapor, and avoid generating excessively large pressure, which helps stably improve the heat dissipation performance of the system.

With reference to the first aspect, in some implementations of the first aspect, the first sealing frame and/or the second sealing frame is sealant, a sealing ring, or sealing foam.

For example, in consideration of a repair requirement of a machine, protective sealing foam may be selected for the first sealing frame and/or the second sealing frame. A material of the protective sealing foam includes silicone foam, polyethylene foam, polyester foam, rubber foam, or the like.

For example, in consideration of aging resistance, resilience, and compression force deflection, the silicone foam may be selected for the first sealing frame and/or the second sealing frame.

For example, a protective sealing foam material may be used for the first sealing frame and/or the second sealing frame, and a microstructure of the protective sealing foam material includes a closed-cell structure, an open-cell structure, and a semi-open-cell structure. In comprehensive consideration of a protective sealing requirement and a compression force deflection requirement, a protective sealing foam of the semi-open-cell structure or the closed-cell structure may be selected for the first sealing frame and/or the second sealing frame.

With reference to the first aspect, in some implementations of the first aspect, the first sealing frame and/or the second sealing frame is of the open-cell structure or the semi-open-cell structure, and a compression rate of a protective sealing material used for the first sealing frame and/or the second sealing frame is greater than 20%.

For example, the compression rate of the protective sealing material used for the first sealing frame and/or the second sealing frame may range from 40% to 65%, or from 35% to 60%.

In this embodiment of this application, if the open-cell structure or the semi-open-cell structure is used for the first sealing frame and/or the second sealing frame, a protective material is required to have a specific compression rate, so that pores of the protective material can be closed during compression, to prevent water vapor leakage and prevent the liquid metal from undergoing the oxidation reaction.

With reference to the first aspect, in some implementations of the first aspect, a nickel-phosphorus plating layer is disposed on a surface of a position at which the heat sink is in contact with the liquid metal, and phosphorus content in the nickel-phosphorus plating layer is greater than or equal to 3 wt%. In other words, a weight percentage of the phosphorus content in the nickel-phosphorus plating layer is greater than or equal to 3%.

For example, the phosphorus content in the nickel-phosphorus plating layer may be greater than or equal to 9 wt%.

In this embodiment of this application, to prevent a metal corrosion phenomenon caused by direct contact between the heat sink and the liquid metal, anti-corrosion plating treatment may be performed on the heat sink. For example, the nickel-phosphorus plating layer may be disposed on the surface of the position at which the heat sink is in contact with the liquid metal. In other words, the nickel-phosphorus plating layer is disposed on the surface of the position at which the heat sink is in contact with the liquid metal, or the nickel-phosphorus plating layer is disposed on a surface of the heat sink, which can prevent the metal corrosion phenomenon caused by direct contact between the heat sink and the liquid metal, thereby avoiding an impact on heat dissipation efficiency of the chip.

With reference to the first aspect, in some implementations of the first aspect, the first sealing frame and the second sealing frame are closely attached between the circuit board and the heat sink.

In this embodiment of this application, the first sealing frame and the second sealing frame may be closely attached between the circuit board and the heat sink. To be specific, ends of the first sealing frame and the second sealing frame are closely attached to the circuit board, and the other ends of the first sealing frame and the second sealing frame are closely attached to the heat sink, so that the chip and the liquid metal are in completely sealed space. This prevents moisture infiltration, corrosion, and leakage of the liquid metal, and prolongs the service life of the liquid metal.

With reference to the first aspect, in some implementations of the first aspect, the heat dissipation package structure further includes a chip substrate. The chip substrate is disposed on the circuit board, and the chip is disposed on a side of the chip substrate that is away from the circuit board.

In this embodiment of this application, as a surface of the circuit board may be uneven, the chip substrate may be disposed on the circuit board. The chip substrate can provide a flat surface, and the chip may be mounted on the chip substrate. This facilitates mounting stability of the chip.

With reference to the first aspect, in some implementations of the first aspect, the first sealing frame and the second sealing frame are closely attached between the chip substrate and the heat sink.

In this embodiment of this application, when the chip substrate is disposed, the first sealing frame and the second sealing frame may be closely attached between the chip substrate and the heat sink. To be specific, ends of the first sealing frame and the second sealing frame are closely attached to the chip substrate, and the other ends of the first sealing frame and the second sealing frame are closely attached to the heat sink, so that the chip and the liquid metal are in completely sealed space. This prevents moisture infiltration, corrosion, and leakage of the liquid metal, and prolongs the service life of the liquid metal.

With reference to the first aspect, in some implementations of the first aspect, the first sealing frame is closely attached between the chip substrate and the heat sink, and the second sealing frame is closely attached between the circuit board and the heat sink.

In this embodiment of this application, when the chip substrate is disposed, the first sealing frame may be closely attached between the chip substrate and the heat sink, and the second sealing frame is closely attached between the circuit board and the heat sink. To be specific, one end of the first sealing frame is closely attached to the chip substrate, the other end of the first sealing frame is closely attached to the heat sink, one end of the second sealing frame is closely attached to the circuit board, and the other end of the second sealing frame is closely attached to the heat sink, so that the chip and the liquid metal are in completely sealed space. This prevents moisture infiltration, corrosion, and leakage of the liquid metal, and prolongs the service life of the liquid metal.

With reference to the first aspect, in some implementations of the first aspect, the heat dissipation package structure further includes a spring arm, one end of the spring arm is fastened to a side of the heat sink that is away from the circuit board, and the other end of the spring arm is configured to lock the heat sink onto the circuit board.

In this embodiment of this application, a structural layout of the spring arm is used, so that a height of the entire heat dissipation package structure is reduced to some extent, meeting a development trend of lightness and thinness of an electronic device. A form of a lateral spring arm structure is used to press the first sealing frame and the second sealing frame, improving sealing reliability of the first sealing frame and the second sealing frame under long-term compression. Moreover, a length and rigidity of the spring arm are adjusted to change sealing pressure and reduce stacking space of the system.

For example, there may be a plurality of spring arms. For example, the plurality of spring arms may be disposed in edge areas on four sides of the heat sink. Through disposition of the plurality of spring arms, the heat sink may be locked onto the circuit board, and the first sealing frame and the second sealing frame between the circuit board and the heat sink may be squeezed, and are in a squeezed state. This prevents the liquid metal from undergoing the oxidation reaction with the water vapor through the pores of the first sealing frame and the second sealing frame.

It should be understood that, through the structural layout of the spring arm and adjustment of the arm length, compressive sealing of sealing materials with different compression rates can be implemented, and a constant compression force can be implemented in a case of long-term compression of the sealing materials, thereby implementing a long-term sealing function. The arm length of the spring arm and the material and the rigidity of the spring arm are adjusted to resolve a problem of limited height layout space of the system, meeting a development requirement for lightness and thinness of the electronic device.

With reference to the first aspect, in some implementations of the first aspect, the heat dissipation package structure further includes a fastener and a connecting piece. The connecting piece is fastened to the circuit board, and the fastener is configured to fasten the spring arm to the connecting piece. For example, the fastener may be a screw, and the connecting piece may be a nut.

In this embodiment of this application, the connecting piece (for example, the nut) may be disposed on the circuit board, and the fastener (for example, the screw) may be fastened to the nut on the circuit board, to implement a fixed connection between the heat sink and the circuit board, so that the first sealing frame and the second sealing frame are in a compressed state. This prevents the liquid metal from undergoing the oxidation reaction with the water vapor through the pores of the first sealing frame and the second sealing frame.

With reference to the first aspect, in some implementations of the first aspect, the heat sink includes an extension portion. The extension portion has a first through hole, and the spring arm has a second through hole. The fastener sequentially passes through the second through hole and the first through hole, and fastens the spring arm to the connecting piece on the circuit board.

In this embodiment of this application, to better implement heat sinks of different structures and to improve connection stability between the heat sink and the circuit board, when the heat sink includes the extension portion, the fastener (for example, the screw) may sequentially pass through the first through hole of the extension portion and the second through hole of the spring arm, to implement a fixed connection to the circuit board.

According to a second aspect, an electronic device is provided. The electronic device includes the heat dissipation package structure according to the first aspect or any one of the implementations of the first aspect.

In this embodiment of this application, when the electronic device uses the heat dissipation package structure according to the first aspect, the heat dissipation package structure can ensure that the electronic device has a good heat dissipation effect, and meet high-density heat dissipation requirements of the electronic device.

### BRIEF DESCRIPTION OF DRAWINGS

FIG. 1 is a diagram of an overall structure of a heat dissipation sealing structure according to an embodiment of this application;
FIG. 2 is a diagram of a partial structure of a heat dissipation sealing structure according to an embodiment of this application;
FIG. 3 is a diagram of a partial structure of a heat dissipation sealing structure according to an embodiment of this application;
FIG. 4 is a cross-sectional view of a heat dissipation sealing structure according to an embodiment of this application;
FIG. 5 is another cross-sectional view of a heat dissipation sealing structure according to an embodiment of this application;
FIG. 6 is another cross-sectional view of a heat dissipation sealing structure according to an embodiment of this application;
FIG. 7 is another cross-sectional view of a heat dissipation sealing structure according to an embodiment of this application;
FIG. 8 is another cross-sectional view of a heat dissipation sealing structure according to an embodiment of this application; and
FIG. 9 is another cross-sectional view of a heat dissipation sealing structure according to an embodiment of this application.

### DESCRIPTION OF EMBODIMENTS

The following describes technical solutions of this application with reference to accompanying drawings.

It should be noted that, in descriptions of embodiments of this application, "/" means "or" unless otherwise specified. For example, A/B may indicate A or B. In this specification, "and/or" describes only an association relationship for describing associated objects and indicates that three relationships may exist. For example, A and/or B may indicate the following three cases: Only A exists, both A and B exist, and only B exists.

The terms "first", "second", and the like in embodiments of this application are merely intended for a purpose of description, and shall not be understood as an indication or implication of relative importance or implicit indication of a quantity of indicated technical features. Therefore, a feature limited by "first", "second", or the like may explicitly or implicitly include one or more features. In addition, in descriptions of embodiments of this application, "a plurality of" means two or more, and "at least one" and "one or more" mean one, two, or more. The singular expression forms "one", "a", "the", "the foregoing", "this", and "the one" are intended to include an expression form like "one or more", unless the opposite is explicitly indicated in the context thereof.

Reference to "an embodiment", "some embodiments", or the like described in the specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "comprise", and "have", and variants thereof all mean "include but are not limited to", unless otherwise specifically emphasized in another manner.

In the descriptions of embodiments of this application, orientations or position relationships indicated by terms "up", "down", "inside", "outside", and the like are defined relative to orientations or positions in which components are schematically placed in the accompanying drawings. It should be understood that these directional terms are relative concepts, and are used for relative description and clarification, but not indicate or imply that a specified apparatus or component needs to have a specific orientation or be constructed and operated in a specific orientation. These directional terms may vary based on changes of positions of the components in the accompanying drawings, and therefore cannot be understood as a limitation on this application.

In embodiments of this application, a same reference numeral represents a same component part or a same part or component. For a same part or component in embodiments of this application, only one part or component may be marked with a reference numeral as an example in the figure. It should be understood that, for another same part or component, the reference numeral is also applicable. In addition, the parts or components in the accompanying drawings are not drawn to actual scale. Dimensions and sizes of the parts or components shown in the figures are merely examples, and should not be understood as a limitation on this application.

In an electronic device, to improve heat dissipation of a chip in the device, a high-performance thermally conductive material is usually used between the chip and a heat sink, to meet high-density heat dissipation requirements of electronic devices. Therefore, liquid metal (liquid metal), as a thermal interface material with high thermal conductivity and ultra-low thermal resistance during application, has been gradually used in an electronic product. A frequently used liquid metal is usually a gallium-based liquid metal, which readily undergoes oxidation reactions with oxygen/water vapor, and is prone to causing corrosion of metals such as aluminum and copper, ultimately causing degradation of heat-conducting performance. Therefore, during actual application, sealing protection needs to be performed on a periphery to achieve anti-oxidation and anti-leakage effects, and anti-corrosion treatment needs to be performed on a contact surface of a component.

Current nickel plating treatment for an aluminum/copper heat sink can only temporarily slow down corrosion of a mechanical part. In a high-temperature heat dissipation scenario, corrosion still occurs quickly. In a conventional technology, in a sealing solution for the liquid metal, a large-sized sealing component in conjunction with a heat sink screw is used to compress a protective sealing material to form sealed space and prevent leakage. The solution has high requirements for barrier properties of a sealing material, and requires a large structural space and a high locking force. In addition, the sealing solution is susceptible to moisture infiltration, mechanical vibration, and long-term reduction in sealing pressure, leading to problems of a long-term sealing failure, liquid leakage, and degraded heat dissipation efficiency of a system.

In conclusion, the sealing component in the conventional technology cannot protect the liquid metal from being affected by moisture, especially cannot protect the liquid metal form undergoing a reaction with the moisture that permeates through an organic matrix. After a high-temperature and high-humidity test, fluidity and thermal performance of the liquid metal deteriorates, making the liquid metal difficult to support long-term use for five years. To maintain a sealing effect, the sealing solution uses large pressure for pressing, for example, through screw fastening, and the sealing material exhibits permanent deformation due to long-term compression. This causes a sealing failure and leakage of the liquid metal. An existing electronic device is becoming increasingly light, thin, and portable. However, an existing sealing system solution requires excessively large stacking space, which is not conducive to a system evolution design. In the high-temperature heat dissipation scenario, nickel is plated on a contact surface of the mechanical part to temporarily delay metal corrosion, but heat dissipation performance is degraded after an interface of the aluminum/copper heat sink is corroded. Due to a limitation on the structural space and the locking force, a low-stress and low-thickness protective material is used, which is likely to cause aggregated oxidation, overflow, leakage, and degraded heat dissipation of the liquid metal.

Therefore, this application provides a heat dissipation package structure and an electronic device, to enable long-term sealing of the liquid metal, prevent moisture infiltration, corrosion, and liquid leakage, and improve long-term heat dissipation performance of a system.

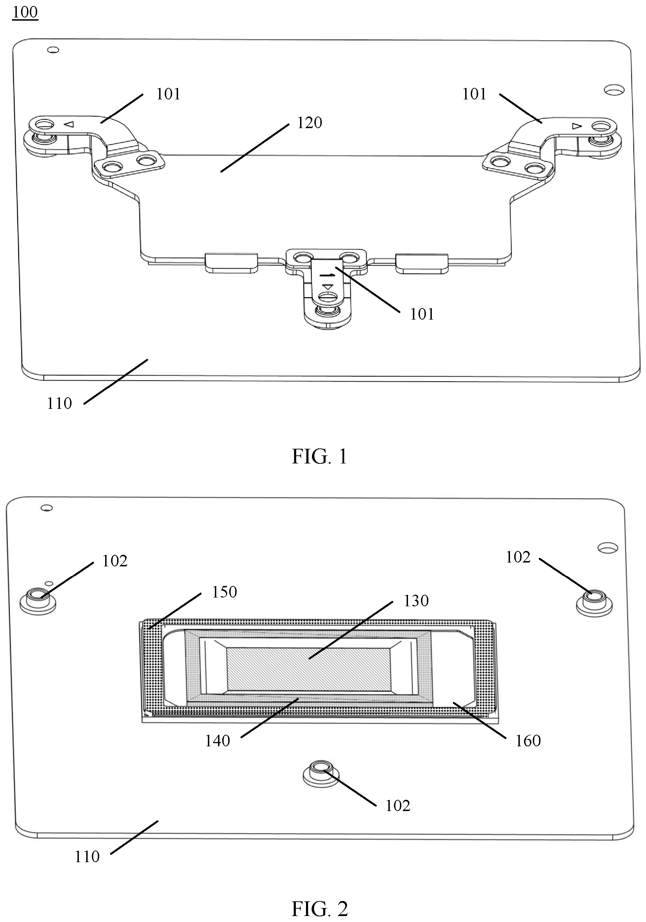

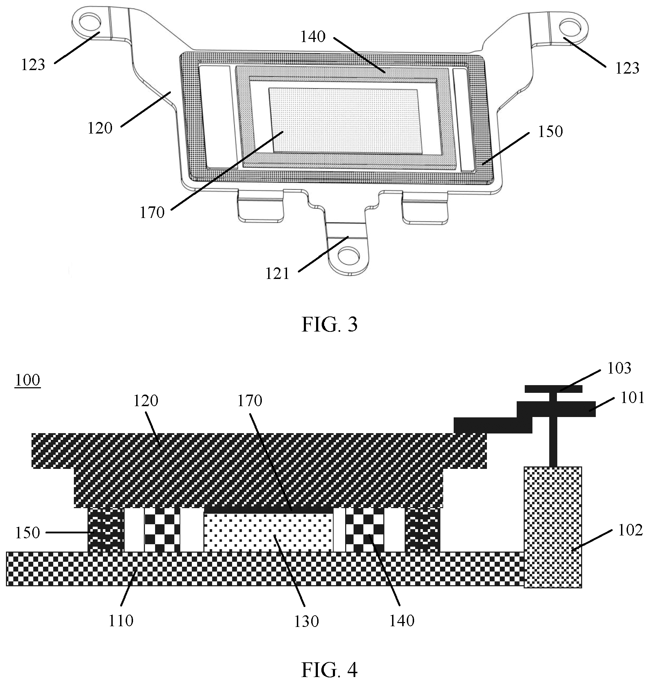

FIG. 1 is a diagram of an overall structure of a heat dissipation package structure according to an embodiment of this application. FIG. 2 and FIG. 3 are diagrams of two partial structures of the heat dissipation package structure according to an embodiment of this application. FIG. 4 to FIG. 9 are cross-sectional views of the heat dissipation package structure according to an embodiment of this application.

With reference to FIG. 1 to FIG. 5, it can be learned that a heat dissipation package structure 100 may include a circuit board 110, a heat sink 120, a chip 130, a first sealing frame 140, a second sealing frame 150, and liquid metal 170.

The chip 130 is disposed on the circuit board 110, and a surface of the chip 130 is coated with the liquid metal 170. It should be understood that the liquid metal 170 (namely, liquid metal) is usually metal or an alloy that is in a liquid state at a room temperature or a low temperature, and has features such as high electrical conductivity, high thermal conductivity, low viscosity, and a wide liquid temperature range. As a thermally conductive material, the liquid metal 170 may be filled between the chip 130 and the heat sink 120, to reduce thermal resistance during application and quickly transfer heat.

The heat sink 120 is disposed on a side of the chip 130 that is away from the circuit board 110, and the heat sink 120 is in contact with the chip 130 through the liquid metal 170. Heat generated by the chip 130 may be transferred to the heat sink 120 through the liquid metal 170 for heat dissipation. Disposing the liquid metal 170 can accelerate heat transfer and improve heat dissipation efficiency.

The first sealing frame 140 is disposed on an outer periphery of the chip 130, and the second sealing frame 150 is disposed on an outer periphery of the first sealing frame 140. The first sealing frame 140 is configured to seal the chip 130 and the liquid metal 170. The second sealing frame 150 is configured to block external air, thereby preventing the external air from entering the first sealing frame 140 and preventing the liquid metal 170 in the first sealing frame 140 from undergoing an oxidation reaction with the external air.

It should be understood that the first sealing frame 140 is an inner sealing frame, and the second sealing frame 150 is an outer sealing frame. The first sealing frame 140 provides first-layer protective sealing to prevent the liquid metal 170 in the first sealing frame 140 from flowing out. The second sealing frame 150 can provide additional protective sealing to prevent the liquid metal 170 that overflows beyond the first sealing frame 140 from continuing to overflow outward, and therefore damaging a peripheral component.

It should be noted that, when the heat sink 120 is locked and fastened to the circuit board 110 in a conventional manner, an assembly gap still exists, and therefore the conventional manner cannot effectively hinder flow and leakage of the liquid metal 170, and cannot block oxygen and water vapor. Consequently, oxidation and thermal resistance deterioration of the liquid metal 170 may be aggravated. In this case, a sealing material needs to be used for protection. In addition, the liquid metal 170 may undergo an oxidation reaction with both water vapor and oxygen, generating a loose and porous oxide, and causing a volume expansion effect. Unoxidized liquid metal is extruded to an edge position, posing a risk of overflow and also damaging the peripheral component. Therefore, a protective structure design greatly affects permeation of water vapor and oxygen, and directly affects a risk of leakage and a service life of the liquid metal. If a single-layer sealing solution is used, poor long-term compression set resistance of a protective material and an open-cell structure of the protective material both greatly increase a risk of liquid metal oxidation and leakage.

Therefore, in this application, a multi-layer protective sealing structure is provided. To be specific, a design of a double-layer sealing structure with the first sealing frame 140 and the second sealing frame 150 is used. This can block moisture, prevent the liquid metal 170 from coming into contact with air and undergoing the oxidation reaction, enable long-term sealing of the liquid metal 170, prevent moisture infiltration, corrosion, and leakage of the liquid metal 170, prolong the service life of the liquid metal 170, and improve long-term heat dissipation performance of the chip 130.

In some examples, a material of the heat sink 120 that is in direct contact with the liquid metal 170 is usually aluminum or copper, and the aluminum/copper is very likely to form an alloy layer with a gallium element in the liquid metal 170, causing a metal corrosion phenomenon on the heat sink 120. This may eventually lead to malfunctioning, a short circuit, or board burnout of the peripheral component. In consideration of this, anti-corrosion treatment needs to be performed on an area of the heat sink 120 that is in direct contact with the liquid metal 170.

Optionally, to prevent the metal corrosion phenomenon caused by direct contact between the heat sink 120 and the liquid metal 170, anti-corrosion plating treatment may be performed on the heat sink 120. For example, an anti-corrosion plating layer (for example, a nickel-phosphorus plating layer) may be disposed on a surface of a position at which the heat sink 120 is in contact with the liquid metal 170, and phosphorus content in the nickel-phosphorus plating layer is greater than or equal to 3 wt%. In other words, a weight percentage of the phosphorus content in the nickel-phosphorus plating layer is greater than or equal to 3%.

Optionally, to effectively reduce corrosion of the aluminum/copper heat sink 120 at a high temperature, the phosphorus content in the nickel-phosphorus plating layer may be set to be greater than or equal to 9 wt%. In other words, the weight percentage of the phosphorus content in the nickel-phosphorus plating layer may be greater than or equal to 9%.

For example, a surface roughness Ra of the heat sink 120 may be less than 1.6. It should be understood that an excessively large surface roughness of the heat sink 120 may affect a coating effect of the liquid metal 170, which affects heat dissipation performance. Therefore, the surface roughness of the heat sink 120 may be limited.

In some examples, a protective material used for the first sealing frame 140 and/or the second sealing frame 150 may be sealant, a sealing ring, or sealing foam.

For example, in consideration of a repair requirement of a machine, protective sealing foam may be selected for the first sealing frame 140 and/or the second sealing frame 150. A material of the protective sealing foam includes silicone foam, polyethylene foam (such as PE foam or EVA foam), polyester foam (such as polyether foam or polyurethane foam), rubber foam (such as ethylene propylene diene monomer EPDM, chloroprene rubber CR, nitrile butadiene rubber NBR, or styrene-butadiene rubber SBR), and the like.

For example, in consideration of aging resistance, resilience, and compression force deflection, the silicone foam may be selected for the first sealing frame 140 and/or the second sealing frame 150.

For example, a protective sealing foam material may be used for the first sealing frame 140 and/or the second sealing frame 150, and a microstructure of the protective sealing foam material may include a closed-cell structure, an open-cell structure, and a semi-open-cell structure.

It should be understood that the open-cell structure, the semi-open-cell structure, and the closed-cell structure are three types of structures in materials science to describe characteristics of pores in a porous material. These characteristics have an important impact on performance of a material (such as water absorption, heat preservation, and mechanical strength).

In a material of the open-cell structure (such as polyurethane foam), pores are interconnected to form an open network. This means that if one end of the material is in contact with liquid, the liquid can permeate into another part of the material through the pores. A material with this structure usually has good moisture absorption, breathability, and elasticity. However, because liquid and gas can flow freely, waterproof and thermal insulation performance of the material is poor.

The semi-open-cell structure is a middle form between the open-cell structure and the closed-cell structure. In the semi-open-cell structure, some pores are interconnected, and other pores are closed. This structure provides a specific degree of liquid and gas permeability, and also has specific blocking performance, and therefore can strike a balance between breathability and water resistance. A material of the semi-open-cell structure is special, and may be used in some specially processed foam or a natural material.

Each pore in a material of the closed-cell structure (such as polyethylene foam or polyisocyanurate foam) is independently closed, and is not interconnected to another pore, forming many tiny bubbles or cavities. This structure provides excellent waterproof, thermal insulation and buoyancy properties for the material. Because gas in the bubbles cannot flow freely, it is difficult for external liquid to permeate. Closed-cell foam is a typical representative, and is widely used in fields such as heat preservation for a building, water sports equipment, a refrigeration box, and a packaging material.

In comprehensive consideration of a protective sealing requirement and a compression force deflection requirement, a protective sealing foam of the semi-open-cell structure or the closed-cell structure may be selected for the first sealing frame 140 and/or for the second sealing frame 150.

In some examples, if the open-cell structure or the semi-open-cell structure is used for the first sealing frame 140 and/or the second sealing frame 150, a compression rate of a protective sealing material used for the first sealing frame 140 and/or the second sealing frame 150 may be greater than 20%. It should be understood that, if the open-cell structure or the semi-open-cell structure is used, a protective material is required to have a specific compression rate, so that pores of the protective material can be closed during compression, to prevent water vapor leakage and prevent the liquid metal 170 in the first sealing frame 140 from undergoing the oxidation reaction.

For example, in consideration of an effect of compression force deflection of a material on interface compression bonding, the compression rate of the protective sealing material may range from 40% to 65%, or from 35% to 60%.

In some examples, to effectively reduce a leakage risk of the liquid metal 170, a ratio of sealed space enclosed by the first sealing frame 140 to an amount of the liquid metal 170 is greater than 2.

For example, in comprehensive consideration of the amount and costs of the liquid metal 170, the ratio of the sealed space enclosed by the first sealing frame 140 to the amount of the liquid metal 170 may range from 2.5 to 3.

In some examples, a width of the first sealing frame 140 is greater than 1 mm, and/or a width of the second sealing frame 150 is greater than 1 mm. By limiting the width of the first sealing frame 140 and/or the width of the second sealing frame 150 to be greater than 1 mm, an excessively narrow width that may affect the sealing effect can be avoided. An appropriate width can implement sealing against water vapor, and avoid generating excessively large pressure, which helps stably improve the heat dissipation performance of the system.

For example, if surrounding structural space is sufficient or the circuit board 110 has sufficient space, the width of the first sealing frame 140 and/or the width of the second sealing frame 150 may be set to be greater than 2 mm.

In an example, as shown in FIG. 4, the first sealing frame 140 and the second sealing frame 150 are closely attached between the circuit board 110 and the heat sink 120. To be specific, ends of both the first sealing frame 140 and the second sealing frame 150 are closely attached to the circuit board 110, and the other ends of both the first sealing frame 140 and the second sealing frame 150 are closely attached to the heat sink 120, so that the chip 130 and the liquid metal 170 are in completely sealed space. This prevents moisture infiltration, corrosion, and leakage of the liquid metal, and prolongs the service life of the liquid metal.

For example, as shown in FIG. 2 and FIG. 5 to FIG. 9, the heat dissipation package structure 100 may further include a chip substrate 160. The chip substrate 160 is disposed on the circuit board 110, and the chip 130 is disposed on a side of the chip substrate 160 that is away from the circuit board 110. In other words, the chip substrate 160 is disposed on the circuit board 110, and the chip 130 is disposed on the chip substrate 160. As a surface of the circuit board 110 may be uneven, the chip substrate 160 may be disposed on the circuit board 110. The chip substrate 160 can provide a flat surface, and the chip 130 can be mounted on the chip substrate 160. This facilitates mounting stability of the chip 130.

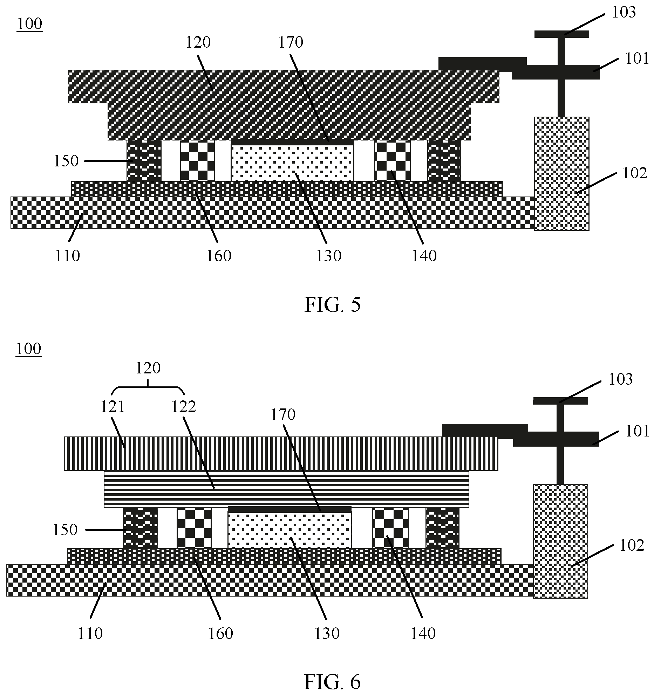

In another example, as shown in FIG. 5 to FIG. 8, both the first sealing frame 140 and the second sealing frame 150 are closely attached between the chip substrate 160 and the heat sink 120. When the chip substrate 160 is disposed, the first sealing frame 140 and the second sealing frame 150 may be closely attached between the chip substrate 160 and the heat sink 120. To be specific, ends of the first sealing frame 140 and the second sealing frame 150 are closely attached to the chip substrate 160, and the other ends of the first sealing frame 140 and the second sealing frame 150 are closely attached to the heat sink 120, so that the chip 130 and the liquid metal 170 are in completely sealed space. This prevents moisture infiltration, corrosion, and leakage of the liquid metal, and prolongs the service life of the liquid metal.

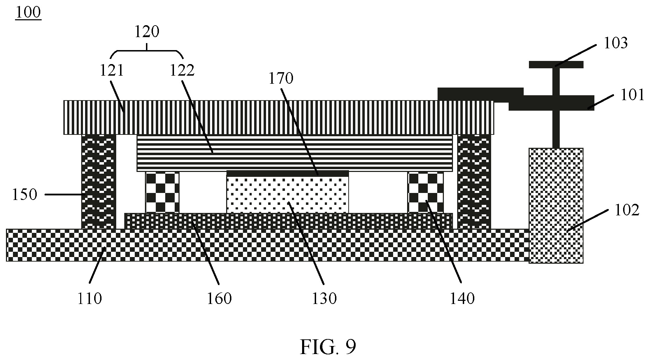

In still another example, as shown in FIG. 9, the first sealing frame 140 is closely attached between the chip substrate 160 and the heat sink 120, and the second sealing frame 150 is closely attached between the circuit board 110 and the heat sink 120. When the chip substrate 160 is disposed, the first sealing frame 140 may be closely attached between the chip substrate 160 and the heat sink 120, and the second sealing frame 150 is closely attached between the circuit board 110 and the heat sink 120. To be specific, one end of the first sealing frame 140 is closely attached to the chip substrate 160, the other end of the first sealing frame 140 is closely attached to the heat sink 120, one end of the second sealing frame 150 is closely attached to the circuit board 110, and the other end of the second sealing frame 150 is closely attached to the heat sink 120, so that the chip 130 and the liquid metal 170 are in completely sealed space. This prevents moisture infiltration, corrosion, and leakage of the liquid metal, and prolongs the service life of the liquid metal.

For example, as shown in FIG. 6 to FIG. 9, the heat sink 120 may include a temperature equalizing plate 121 and a copper plate 122. The copper plate 122 is in contact with the liquid metal 170, and the temperature equalizing plate 121 is disposed on a side of the copper plate 122 that is away from the chip 130. The temperature equalizing plate 121 may be a heat pipe (vapor chamber, VC).

The first sealing frame 140 may be closely attached between the chip substrate 160 and the copper plate 122 of the heat sink 120; or the first sealing frame 140 may be closely attached between the circuit board 110 and the copper plate 122 of the heat sink 120; or the first sealing frame 140 may be closely attached between the circuit board 110 and the temperature equalizing plate 121 of the heat sink 120; or the first sealing frame 140 may be closely attached between the chip substrate 160 and the temperature equalizing plate 121 of the heat sink 120.

The second sealing frame 150 may be closely attached between the chip substrate 160 and the copper plate 122 of the heat sink 120; or the second sealing frame 150 may be closely attached between the circuit board 110 and the copper plate 122 of the heat sink 120; or the second sealing frame 150 may be closely attached between the chip substrate 160 and the temperature equalizing plate 121 of the heat sink 120; or the second sealing frame 150 may be closely attached between the circuit board 110 and the temperature equalizing plate 121 of the heat sink 120.

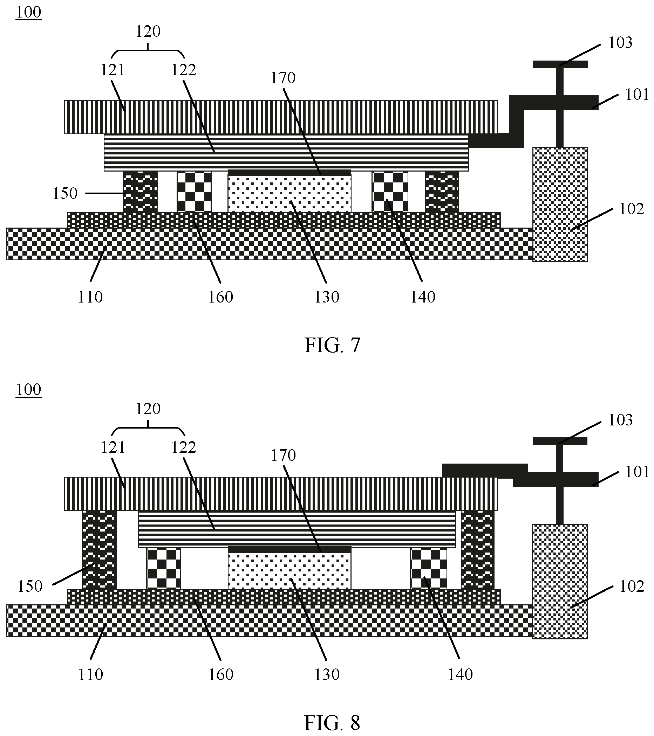

For example, as shown in FIG. 6 and FIG. 7, the first sealing frame 140 may be closely attached between the chip substrate 160 and the copper plate 122 of the heat sink 120, and the second sealing frame 150 may also be closely attached between the chip substrate 160 and the copper plate 122 of the heat sink 120.

For example, as shown in FIG. 8, the first sealing frame 140 may be closely attached between the chip substrate 160 and the copper plate 122 of the heat sink 120, and the second sealing frame 150 may be closely attached between the chip substrate 160 and the temperature equalizing plate 121 of the heat sink 120.

For example, as shown in FIG. 9, the first sealing frame 140 may be closely attached between the chip substrate 160 and the copper plate 122 of the heat sink 120, and the second sealing frame 150 may be closely attached between the circuit board 110 and the temperature equalizing plate 121 of the heat sink 120.

In some examples, as shown in FIG. 1 and FIG. 4 to FIG. 9, the heat dissipation package structure 100 may further include a spring arm 101. One end of the spring arm 101 is fastened to a side of the heat sink 120 that is away from the circuit board 110, and the other end of the spring arm 101 is configured to lock the heat sink 120 onto the circuit board 110. For example, a material of the spring arm 101 may be metal with good elasticity, for example, elastic stainless steel or spring steel 65Mn.

For example, a structural layout of the spring arm 101 in this application is used, so that a height of the entire heat dissipation package structure 100 can be reduced to about 3.7 mm, meeting a development trend of lightness and thinness of an electronic device. A form of a lateral spring arm structure is used to press the first sealing frame 140 and the second sealing frame 150, improving sealing reliability of the first sealing frame 140 and the second sealing frame 150 under long-term compression. A length and rigidity of the spring arm are adjusted to change sealing pressure and reduce stacking space of the system.

It should be understood that, through the structural layout of the spring arm 101 and adjustment of the arm length, compressive sealing of sealing materials with different compression rates can be implemented, and a constant compression force can be implemented in a case of long-term compression of the sealing materials, thereby implementing a long-term sealing function. The arm length of the spring arm 101 and the material and the rigidity of the spring arm 101 are adjusted to resolve a problem of limited height layout space of the system, meeting a development requirement for lightness and thinness of the electronic device.

For example, the lateral spring arm structure is used, and the arm length and the rigidity of the spring arm 101 are adjusted, so that clamping pressure of the heat sink 120 and pressure of the sealing ring are ensured, a life degradation rate is low, and the problem of limited height layout space is resolved. This is applicable to an application of a light and thin product.

In an example, as shown in FIG. 7, if the heat sink 120 includes the temperature equalizing plate 121 and the copper plate 122, the spring arm 101 may alternatively be disposed on a side of the copper plate 122 that is away from the circuit board 110, and the temperature equalizing plate 121 is disposed above the copper plate 122 and the spring arm 101. In this case, the first sealing frame 140 and the second sealing frame 150 may be disposed between the chip substrate 160 and the copper plate 122.

In some examples, as shown in FIG. 4 to FIG. 9, the heat dissipation package structure may further include a fastener 103 (for example, a screw). The fastener 103 may pass through the spring arm 101 and be fastened to the circuit board 110. In other words, the fastener 103 may pass through a through hole on the spring arm 101 to lock the heat sink 120 onto the circuit board 110.

For example, the heat dissipation package structure may further include a connecting piece 102 (for example, a nut). The connecting piece 102 may be fastened to the circuit board 110, and the fastener 103 (for example, the screw) may pass through the through hole on the spring arm 101, and be fastened to the connecting piece 102 on the circuit board 110.

It should be understood that a layout position and a size of the spring arm 101 may be correspondingly adjusted and designed based on a layout of the heat sink 120 or the chip 130.

It should be noted that, in this application, the connecting piece 102 (for example, the nut) may be disposed on the circuit board 110, and the fastener 103 (for example, the screw) may be fastened to the nut on the circuit board 110, to implement a fixed connection between the heat sink 120 and the circuit board 110, so that the first sealing frame 140 and the second sealing frame 150 are in a compressed state. This prevents the liquid metal 170 from undergoing the oxidation reaction with the water vapor through the pores of the first sealing frame 140 and the second sealing frame 150.

In consideration of different structures of different heat sinks 120, in some examples, as shown in FIG. 3, the heat sink 120 may include an extension portion 123. The extension portion 123 has a first through hole, the spring arm 101 has a second through hole, and the fastener 103 may sequentially pass through the second through hole and the first through hole, and be fastened to the circuit board 110.

It should be understood that, to better implement the heat sinks 120 of different structures and to improve connection stability between the heat sink 120 and the circuit board 110, when the extension portion 123 is disposed on the heat sink 120, the fastener 103 (for example, the screw) may sequentially pass through the first through hole of the extension portion 123 and the second through hole of the spring arm 101, to implement a fixed connection to the connecting piece 102 (for example, the nut) on the circuit board 110.

The foregoing describes the heat dissipation package structure 100 according to embodiments of this application with reference to FIG. 1 to FIG. 9. Based on this, an embodiment of this application further provides an electronic device. The electronic device may include the heat dissipation package structure 100 shown in FIG. 1 to FIG. 9, to meet a requirement for high heat dissipation performance of the electronic device.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A heat dissipation package structure, comprising:
a circuit board (110), wherein a chip (130) is disposed on the circuit board (110), and a surface of the chip (130) is coated with liquid metal (170); and
a heat sink (120), wherein the heat sink (120) is disposed on a side of the chip (130) that is away from the circuit board (110), the heat sink (120) is in contact with the chip (130) through the liquid metal (170), and the liquid metal (170) is configured to transfer heat from the chip (130) to the heat sink (120); and
a first sealing frame (140) is disposed on an outer periphery of the chip (130), a second sealing frame (150) is disposed on an outer periphery of the first sealing frame (140), the first sealing frame (140) is configured to seal the chip (130) and the liquid metal (170), and the second sealing frame (150) is configured to block external air from entering the first sealing frame (140).

2. The heat dissipation package structure according to claim 1, wherein a ratio of sealed space enclosed by the first sealing frame (140) to an amount of the liquid metal (170) is greater than 2.

3. The heat dissipation package structure according to claim 1 or 2, wherein a compression rate of a protective sealing material used for the first sealing frame (140) and/or the second sealing frame (150) is greater than 20%.

4. The heat dissipation package structure according to any one of claims 1 to 3, wherein a width of the first sealing frame (140) and/or the second sealing frame (150) is greater than 1 mm.

5. The heat dissipation package structure according to any one of claims 1 to 4, wherein a nickel-phosphorus plating layer is disposed on a surface of a position at which the heat sink (120) is in contact with the liquid metal (170), and phosphorus content in the nickel-phosphorus plating layer is greater than or equal to 3 wt%.

6. The heat dissipation package structure according to any one of claims 1 to 5, wherein the first sealing frame (140) and the second sealing frame (150) are closely attached between the circuit board (110) and the heat sink (120).

7. The heat dissipation package structure according to any one of claims 1 to 5, wherein the heat dissipation package structure further comprises a chip substrate (160), the chip substrate (160) is disposed on the circuit board (110), and the chip (130) is disposed on a side of the chip substrate (160) that is away from the circuit board (110).

8. The heat dissipation package structure according to claim 7, wherein the first sealing frame (140) and the second sealing frame (150) are closely attached between the chip substrate (160) and the heat sink (120); or
the first sealing frame (140) is closely attached between the chip substrate (160) and the heat sink (120), and the second sealing frame (150) is closely attached between the circuit board (110) and the heat sink (120).

9. The heat dissipation package structure according to any one of claims 1 to 7, wherein the heat dissipation package structure further comprises a spring arm (101), one end of the spring arm (101) is fastened to a side of the heat sink (120) that is away from the circuit board (110), and the other end of the spring arm (101) is configured to lock the heat sink (120) onto the circuit board (110).

10. The heat dissipation package structure according to claim 9, wherein the heat dissipation package structure further comprises a connecting piece (102) and a fastener (103), the connecting piece (102) is fastened to the circuit board (110), and the fastener (103) is configured to fasten the spring arm (101) to the connecting piece (102).

11. The heat dissipation package structure according to claim 10, wherein the heat sink (120) comprises an extension portion (123), the extension portion (123) is provided with a first through hole, and the spring arm (101) is provided with a second through hole; and
the fastener (103) sequentially passes through the second through hole and the first through hole, and fastens the spring arm (101) to the connecting piece (102).

12. The heat dissipation package structure according to any one of claims 1 to 11, wherein the first sealing frame (140) and/or the second sealing frame (150) is a sealant, a sealing ring, or sealing foam.

13. An electronic device, comprising the heat dissipation package structure according to any one of claims 1 to 12.
